(19) Europäisches Patentamt
European Patent Office
Office européen des brevets

(11) Veröffentlichungsnummer : **0 062 611**
**B1**

(12) # EUROPÄISCHE PATENTSCHRIFT

(45) Veröffentlichungstag der Patentschrift : **24.04.85**

(51) Int. Cl.⁴ : **G 03 C 1/68**, G 03 F 7/10

(21) Anmeldenummer : **82810140.2**

(22) Anmeldetag : **29.03.82**

(54) **Photopolymerisationsverfahren.**

(30) Priorität : **02.04.81 GB 8110403**

(43) Veröffentlichungstag der Anmeldung : **13.10.82 Patentblatt 82/41**

(45) Bekanntmachung des Hinweises auf die Patenterteilung : **24.04.85 Patentblatt 85/17**

(84) Benannte Vertragsstaaten : **BE CH DE FR GB IT LI NL SE**

(56) Entgegenhaltungen :
**FR-A- 2 272 107**
**GB-A- 940 878**
**US-A- 2 929 710**
**US-A- 2 980 535**
**US-A- 3 575 925**

(73) Patentinhaber : **CIBA-GEIGY AG**
**Postfach**
**CH-4002 Basel (CH)**

(72) Erfinder : **Green, George Edward, Dr.**
**14 Vine Close**
**Stapleford Cambridge CB2 5BZ (GB)**
Erfinder : **Losert, Ewald**
**Habsburgerstrasse 30**
**CH-4310 Rheinfelden (CH)**
Erfinder : **Paul, John Gordon, Dr.**
**13 Alma Terrace Falkirk**
**Stirlingshire Schottland (GB)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 062 611 B1

Jouve, 18, rue St-Denis, 75001 Paris, France

**Beschreibung**

Vorliegende Erfindung betrifft ein Photopolymerisations- und Photovernetzungsverfahren sowie insbesondere ein solches Verfahren zur Erzeugung von Abbildungen.

Ueblicherweise erfolgt die Erzeugung einer Abbildung mittels Photopolymerisation, indem man einen Träger mit einer Lösung einer photopolymerisierbaren Substanz in einem flüchtigen organischen Lösungsmittel beschichtet, das Lösungsmittel abdampft oder verdampfen lässt, so dass ein Film der photopolymerisierbaren Substanz verbleibt, den Film mit aktinischer Strahlung wie durch eine Abbildung hindurch bestrahlt, wodurch die von der Strahlung getroffenen Stellen des Films photopolymerisiert (und weniger löslich) werden, während die von der Strahlung abgeschirmten Stellen weitgehend unverändert bleiben, und dann die unbestrahlten, unphotopolymerisierten Stellen des Films mittels eines geeigneten Lösungsmittels, welches die bestrahlten, photopolymerisierten Stellen nicht auflöst, weglöst. Diese letzte Stufe ist üblicherweise als « Entwicklung » bekannt.

Es wäre wünschenswert, ein Verfahren zur Verfügung zu haben, bei dem eine Schicht einer photopolymerisierbaren Substanz auf einen Träger aufgebracht und diese Schicht ohne Anwendung organischer Lösungsmittel in einen weitgehend festen, klebfreien, bestrahlungsfertigen Zustand überführt würde. In dieser Stufe würde man nicht nur die Anwendung von Lösungsmitteln, die zu Toxizitäts- und Brennbarkeitsproblemen führen könnten und auch Rückgewinnungskosten verursachen, vermeiden, sondern auch die Herstellung beschichteter, bestrahlungsfertiger Träger auf kontinuierliche Weise würde erleichtert werden.

Es wurde nun gefunden, dass man diese Aufgabe dadurch lösen kann, dass man gewisse Substanzen, die im Molekül zwei Arten von Gruppen enthalten, über welche Photopolymerisation mit beträchtlich voneinander verschiedenen Geschwindigkeiten eintreten kann, verwendet. Die Gruppen werden so ausgewählt, dass Photopolymerisation einer Schicht einer flüssigen Zusammensetzung zu einer festen, im wesentlichen klebfreien Schicht, die jedoch in bestimmten Lösungsmitteln noch löslich ist, rasch eintritt. Anschließend setzt man Stellen der Schicht einer wesentlich grösseren Menge aktinischer Strahlung aus, wobei Photovernetzung über den anderen Typus von Gruppe in den bereits photopolymerisierten Molekülen der Schicht eintritt und die der Photovernetzung unterworfenen Stellen der Schicht viel beständiger gegen Auflösung in den Lösungsmitteln werden.

Unveröffentlichte Versuche der Anmelderin haben gezeigt, dass zahlreiche möglicherweise nützliche Verbindungen, die zwei Typen normalerweise photopolymerisationsfähiger Einheiten enthalten, bei einem solchen Verfahren keine befriedigenden Ergebnisse liefern, da die Photopolymerisation in der ersten Stufe erheblich verzögert wird, anscheinend als Folge der Gegenwart eines anderen Typs photopolymerisierbarer Einheit, trotz des Einbaus verschiedener Photoinitiatoren und Photosensibilisatoren. Weitere unveröffentlichte Versuche der Anmelderin mit Gemischen aus zwei Verbindungen, wovon eine normalerweise photopolymerisationsfähige Einheit und die andere eine unterschiedliche, normalerweise photovernetzbare Einheit enthalten, lieferten unbefriedigende Ergebnisse, offensichtlich wegen Hemmung der Photovernetzungsreaktion.

Es wurde nun gefunden, dass man das gewünschte Verfahren realisieren kann, wenn man eine Verbindung einsetzt, die im selben Molekül sowohl eine oder mehrere Acryloyl- oder Methacryloylgruppen als auch mindestens eine Anthrylgruppe enthält.

Ein Gegenstand dieser Erfindung ist dementsprechend ein Verfahren zur Erzeugung einer Abbildung, welches dadurch gekennzeichnet ist, dass man (1) eine auf einem Träger aufgebrachte Schicht aus einer flüssigen Zusammensetzung, die eine Verbindung (A) mit sowohl mindestens einer Gruppe der Formel

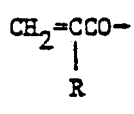 (I)

als auch mindestens einer Gruppe der Formel

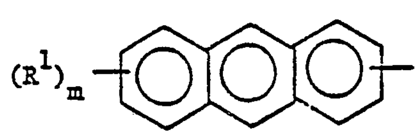 (II)

im selben Molekül enthält, wobei R ein Wasserstoffatom oder eine Methylgruppe bedeutet, $R^1$ ein Chlor- oder Bromatom, eine Methylgruppe oder eine Nitrogruppe darstellt und m null, 1 oder 2 ist, so mit aktinischer Strahlung belichtet, dass sich die Schicht durch Photopolymerisation von (A) über die Gruppe bzw. Gruppen der Formel I verfestigt und im wesentlichen klebfrei wird, jedoch weitgehend photovernetzbar bleibt, und anschliessend (2) die so verfestigte Schicht durch eine bildtragende Vorlage mit weitgehend undurchsichtigen und weitgehend durchsichtigen Stellen hindurch mit einer wesentlich grösseren Menge aktinischer Strahlung belichtet, so dass die weiterbelichtete(n) Stelle(n) der photopolymerisierten Schicht über die Gruppe bzw. Gruppen der Formel II Photovernetzung eingehen, und (3) die Abbildung durch Auflösung der nicht vernetzten Stellen der Schicht in einem Lösungsmittel entwickelt.

In der U.S. Patentschrift Nr. 2 980 535 ist die Herstellung von photopolymerisierbaren Polymeren unter Einbau von Anthracenanteilen beschrieben. So erhält man durch Acetalisierung von Polyvinylalkohol mit Anthracen-9-aldehyd lichtempfindliche Polymere ; um die Löslichkeit des Produkts in z. B. chlorierten aliphatischen Kohlenwasserstoffen zu erhöhen, behandelt man es mit Essigsäureanhydrid, was ein Einheiten der Formel

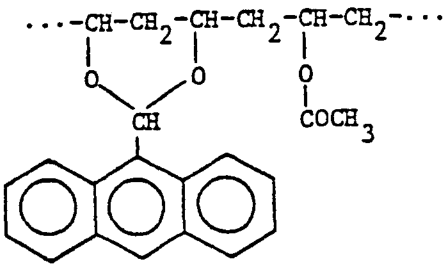

(III)

enthaltendes acetyliertes Acetal liefert.

In weiteren Beispielen wird Polyvinylacetat teilweise verseift und mit Anthracen-9-aldehyd ein Acetal gebildet, oder Polyvinylbutyral wird mit Anthracen-9-aldehyd umacetalisiert. Es wird keine Anregung dazu gegeben, durch Photopolymerisation einer sowohl Acryloyl- oder Methacryloylgruppen als auch Anthracenanteile enthaltenden Verbindung ein Anthracenanteile enthaltendes, noch photovernetzbares Produkt zu bilden.

Aus der britischen Patentschrift Nr. 940 878 ist ein elektrophotographisches Material bekannt, das aus einem elektrisch leitenden Träger mit einer photoleitenden Beschichtung, die noch ein Polymer eines aromatischen oder heterocyclischen Esters der Acrylsäure oder einer Alpha-alkylacrylsäure enthält, besteht. Das Polymer enthält Einheiten der Formel $—CH_2—C(R_2)—COOR_1$, worin $R_1$ für einen gegebenenfalls substituierten Aryl-, Aralkyl-, heterocyclischen oder Hetero-alkylrest und $R_2$ für ein Wasserstoffatom oder einen Alkylrest stehen. Bevorzugte Reste $R_1$ sind unter anderem solche, die sich von Anthracen ableiten ; geeignete Monomere lassen sich dadurch herstellen, dass man ein hydroxylhaltiges Anthracenderivat wie 2-Hydroxyanthracen, 9-Hydroxyanthracen oder 9-Hydroxymethylanthracen mit Acryloylchlorid umsetzt. Die Polymeren lassen sich nach üblichen Polymerisationsverfahren unter Verwendung von Katalysatoren wie Peroxyden oder Azoverbindungen erhalten. Die photoleitende Beschichtung erhält man durch Auftragen des Polymeren in Form einer Lösung in einem organischen Lösungsmittel oder einer wässrigen oder nicht-wässrigen Dispersion auf den Träger und anschliessendes Entfernen des flüssigen Mediums durch Verdampfen. Bei der Bildung einer elektrophotographischen Abbildung wird die Beschichtung mittels einer Coronaentladung aufgeladen und dann hinter einer Vorlage mit dem von Hochdruckquecksilberdampflampen ausgestrahlten UV-Licht belichtet ; danach wird sie mit einem Entwickler bestäubt, der an den bei der Belichtung nicht vom Licht getroffenen Stellen anhaftet, um eine der Vorlage entsprechende Abbildung sichtbar zu machen.

Die französische Patentschrift Nr. 2 272 107 offenbart Anthracenmonomere der Formel

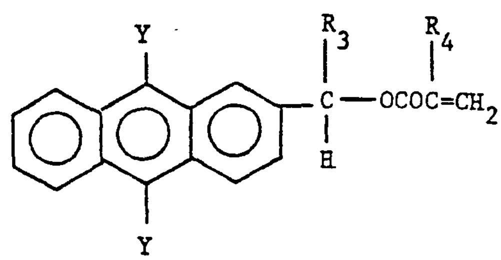

(IV)

worin $R_3$ und $R_4$ je für ein Wasserstoffatom oder eine Alkylgruppe sowie X und Y je für ein Wasserstoff-, Chlor- oder Bromatom oder eine Alkyl- oder Phenylgruppe stehen, sowie die Herstellung solcher Monomeren. Die 2-Anthrylmonomeren werden nach üblichen radikalgestarteten Additionspolymerisationsmethoden polymerisiert. Es wird dabei angegeben, dass es wünschenswert sei, die Monomeren während der Polymerisation vor elektromagnetischer Strahlung zu schützen, da elektronisch angeregte Anthracengruppen wohlbekannterweise die Radikalpolymerisation hemmen können. Die erzeugten Polymeren sollen zur Verwendung in photoleitenden Schichten in elektrophotographischen Verfahren geeignete hochmolekulare Materialien sein. Als Polymere werden Homopolymere aus 2-Anthrylmethylmethacrylat und 1-(2-Anthryl)-äthylmethacrylat sowie Copolymere dieser Methacrylate mit Methylmethacrylat bevorzugt.

Ferner hat der Erfinder des oben genannten Patents die Herstellung und Polymerisation von 2-anthrylsubstituierten Monomeren in Macromolecules, 1975, *8* (1), 8-9, beschrieben. Im Zusammenhang

mit den bei der Polymerisation von anthracengruppen-haltigen Vinylmonomeren auftretenden Problemen führte er aus, (i) dass es die sehr hohe Reaktionsfreudigkeit der Anthracengruppe gegenüber freien Radikalen unmöglich mache, ein hochmolekulares 9-Vinylanthracenpolymer zu synthetisieren, (ii) dass Anthracen in Abwesenheit von UV-Strahlung die Radikalpolymerisation des Methylmethacrylats nicht störe und (iii) dass die lichtinduzierte Polymerisation von Methylmethacrylat in Gegenwart von Benzoylperoxyd ebenfalls durch Anthracen gehemmt werde. Nach diesen Ausführungen legte er seine Annahme dar, dass eine durch eine covalente Bindung an Anthracen gebundene Methacrylatgruppe polymerisierbar sein sollte. Anschliessend beschrieb er Versuche, die die Richtigkeit jener Annahme bewiesen ; die Polymerisation von 1-(2-Anthryl)-äthyl-methacrylat wurde unter Schutz der Reaktionspartner gegen Licht durchgeführt.

G.I. Lashkov u. a., in Doklady Akademii Nauk SSR, 1974, *214* (4), 850-853, haben die Photodimerisierung von anthracengruppenhaltigen Polymeren in Dioxanlösung beschrieben. Zu den erwähnten Polymeren, deren Herstellung nicht beschrieben ist, gehören ein Homopolymer des 9-Anthrylmethylmethacrylats und dessen Copolymer mit Methylmethacrylat.

Aus der U.S. Patentschrift Nr. 3 807 999 ist die Photocycloadditionspolymerisation von Bis-anthracenen der Formel $A—(CH_2)_qOCOR_5COO(CH_2)_q—A$ oder $A—COOR_5OCO—A$, worin A jeweils eine 9-Anthrylgruppe, $R_5$ eine Alkylengruppe und q 1 oder 2 sind, bekannt. Die Polymerisation erfolgt durch Belichtung mit ultravioletter Strahlung bei 365 nm. Die Polymerisation soll reversibel sein ; die gebildeten Polymeren können durch Erhitzen oder Bestrahlung bei 254 nm abgebaut und die abgebauten Produkte durch Bestrahlung bei 365 nm erneut polymerisiert werden. Die meisten der Polymeren sollen halogenalkanlöslich sein ; falls sie wegen Kristallisation in diesen Lösungsmitteln unlöslich werden, findet man, dass sie in Dimethylsulfoxyd löslich sind ; dies wird als Beweis dafür angesehen, dass sich keine vernetzten Strukturen bilden. Es wird eine Methode zur Aufzeichnung von Informationen beschrieben, bei der ein durch Photocycloaddition gebildetes Polymer auf einen Träger aufgebracht und bildweise einer Erhitzung, zum Beispiel mit einem Infrarotlaser, ausgesetzt wird. Die so entstandene Abbildung wird mit einem UV-Laser abgetastet und mittels einer für die Excimer-fluoreszenz, die an den Stellen auftritt, wo das Polymer durch den Infrarotlaser abgebaut wurde, empfindlichen Photozelle aufgezeichnet.

Die U.S. Patentschrift Nr. 3 131 060 offenbart photoleitende Vinylpolymere mit wiederkehrenden Gruppen der Formel

$$—CH_2—C(R_8)—R_6—(CH{=}CH)_{r-1}—CO(CH{=}CH)_s—R_7—$$

worin $R_6$ einen aromatischen oder heterocyclischen Kern, $R_7$ einen aromatischen Kern wie einen Anthracenkern oder heterocyclischen Kern und $R_8$ ein Wasserstoffatom oder eine Niederalkylgruppe darstellen sowie r und s je 1 oder 2 sind. Die Polymere lassen sich nach verschiedenen Methoden herstellen, wobei die Initiierung durch freie Radikale, Ionenbildung oder Bestrahlung mit aktinischem Licht erfolgt. Die Polymerisation lässt sich auch an Ort und Stelle auf einem Träger durchführen. Ein Beispiel beschreibt die Reaktion von Poly-(vinylacetophenon) mit 9-Anthraldehyd zu einem Polymer der obigen Formel, worin $R_6$ einen Benzolkern, $R_7$ einen Anthracenkern und $R_8$ ein Wasserstoffatom darstellen sowie r und s 1 sind.

Ferner sind aus der U.S. Patentschrift Nr. 3 113 022 photoleitende Polymere der im vorangehenden Patent offenbarten Art sowie zahlreiche weitere Arten photoleitender Polymeren bekannt. Die Anwendung dieser Polymeren in elektrophotographischen Verfahren wird beschrieben. Es wird angegeben, dass dabei keine Unlöslichmachung der Polymeren eintritt bzw. dass, wenn diese eintritt, sie bei dem Bildaufzeichnungsvorgang keine wichtige Rolle spielt ; die zur Erzeugung der leitenden latenten Abbildung erforderliche Beleuchtung ist viel kleiner als die zur Einleitung einer Vernetzung der Polymeren erforderliche Beleuchtung.

Ueblicherweise wird die im erfindungsgemässen Verfahren eingesetzte Verbindung (A) pro Durchschnittsmolekül bis vier Gruppen der Formel I und bis vier Gruppen der Formel II enthalten ; im allgemeinen besitzt sie ein Molekulargewicht von höchstens 2 000. Bevorzugt sind die Gruppe(n) der Formel I sowie die Gruppe(n) der Formel II jeweils direkt an ein Kohlenstoff-, Sauerstoff- oder Stickstoffatom bzw. -atome gebunden ; Verbindungen mit 1-Anthryl-, 2-Anthryl- oder insbesondere 9-Anthrylgruppen als Gruppe(n) der Formel II werden besonders bevorzugt.

Als (A) geeignete Verbindungen lassen sich dadurch erhalten, dass man gleichzeitig oder in beliebiger Reihenfolge eine Verbindung mit zwei oder mehr direkt an ein Sauerstoff-, Stickstoff- oder Schwefelatom bzw. -atome gebundenen Glycidylgruppen mit Acryl- oder Methacrylsäure und mit einer Anthracencarbonsäure der Formel

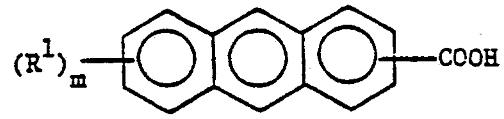

(V)

worin $R^1$ und m die unter Formel II angegebenen Bedeutungen haben, insbesondere Anthracen-1-carbonsäure, Anthracen-2-carbonsäure oder Anthracen-9-carbonsäure umsetzt.

Weitere zur Verwendung als (A) geeignete Verbindungen sind analog durch Einsatz eines Hydroxyanthracens der Formel

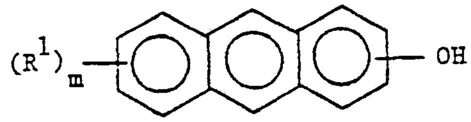 (VI)

worin $R^1$ und m die unter Formel II angegebenen Bedeutungen habe, insbesondere 1-Anthranol und 2-Anthranol, anstelle der Anthracencarbonsäure der Formel V erhältlich.

Zur Verwendung als (A) geeignete Verbindungen kann man auf ähnliche Weise, unter Ersatz der Anthracencarbonsäure der Formel V durch einen anthracenhaltigen Alkohol der Formel

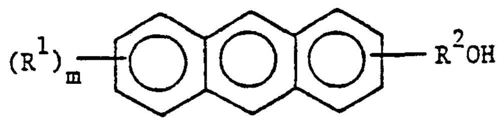 (VII)

worin $R^1$ und m die unter Formel II angegebenen Bedeutungen haben und $R^2$ eine Alkylen- oder Alkylidengruppe mit 1 bis 4 Kohlenstoffatomen wie eine Methylen- oder Aethylengruppe, insbesondere 1-(Hydroxymethyl)-anthracen und 1-(2-Anthryl)-äthanol, bedeutet, erhalten.

Noch weitere zur Verwendung als (A) geeignete Verbindungen kann man auf ähnliche Weise erhalten, wenn man anstelle der Anthracencarbonsäure der Formel V ein Aminoanthracen der Formel

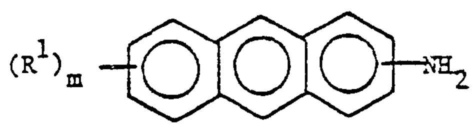 (VIII)

worin $R^1$ und m die unter Formel II angegebenen Bedeutungen haben, wie 2-Aminoanthracen und 9-Aminoanthracen, einsetzt.

Weitere ebenfalls zur Verwendung als (A) geeignete Verbindungen sind auf ähnliche Weise erhältlich, wenn man die Anthracencarbonsäure der Formel V durch eine Anthracencarbonsäure der Formel

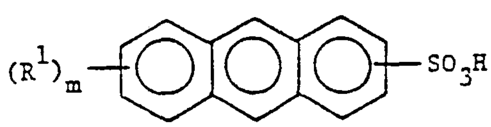 (IX)

worin $R^1$ und m die unter Formel II angegebenen Bedeutungen haben, wie Anthracen-2-sulfonsäure und Anthracen-9-sulfonsäure, ersetzt.

Im Fall der Verwendung einer anthracenhaltigen Carbonsäure bzw. eines Phenols oder einer Sulfonsäure kann man, wenn erwünscht, diese der Polyglycidylverbindung gleichzeitig mit der (Meth)acrylsäure zusetzen.

Als Verbindung (A) verwendbare Substanzen sind dementsprechend solche der allgemeinen Formel

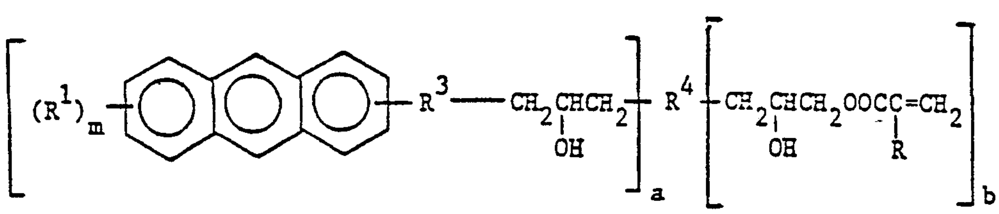 (X)

worin R die unter Formel I sowie $R^1$ und m die unter Formel II angegebenen Bedeutungen haben, $R^3$ eine Gruppe der Formel —COO—, —O—, —$R^2$O—, —NH— oder —$SO_3$— bedeutet, wobei $R^2$ die unter Formel VII angegebene Bedeutung hat, a und b je eine ganze Zahl von mindestens 1 und vorzugsweise je höchstens 4 sind und $R^4$ nach Wegnahme von (a + b) direkt an ein Sauerstoff-, Stickstoff- oder Schwefelatom bzw. -atome gebundenen Glycidylgruppen den Rest einer mindestens (a + b) solche Glycidylgruppen enthaltenden Verbindung darstellt.

Methoden zum Oeffnen von 1,2-Epoxidringen in Glycidylverbindungen mittels Acryl- oder Methacrylsäure sowie mit Carbonsäuren, Phenolen, Alkoholen, primären Aminen und Sulfonsäuren sind wohlbekannt.

Es ist ersichtlich, dass wegen der Art ihrer Bildung unter Konkurrenz zwischen der (Meth)acrylsäure und der anthracenhaltigen Carbonsäure bzw. dem Phenol, Alkohol, Amin oder der Sulfonsäure für die Epoxidgruppen die Verbindungen der Formel X von Addukten aus jener Verbindung mit zwei oder mehr solchen Glycidylgruppen und den Anthracenderivaten der Formeln V bis IX allein sowie Addukten jener Verbindung mit zwei oder mehr solchen Glycidylgruppen und Acrylsäure oder Methacrylsäure allein, d. h. Verbindungen der Formel

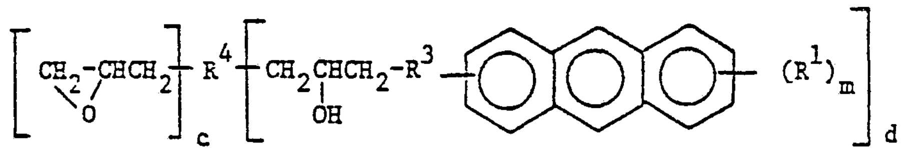
(XI)

und Verbindungen der Formel

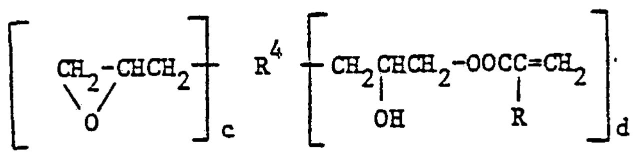
(XII)

worin R die unter Formel I, $R^1$ und m die unter Formel X sowie $R^3$ und $R^4$ die unter Formel X angegebenen Bedeutungen haben, c null oder eine ganze positive Zahl und d eine ganze Zahl von mindestens eins sind, wobei die Summe (c + d) gleich der Summe (a + b) ist, begleitet sind.

Das Ausmass der Bildung der Nebenprodukte der Formel X oder XI hängt natürlich von den Anteilen der drei Typen eingesetzter Reaktionspartner ab. Die Durchführung des erfindungsgemässen Verfahrens wird durch die Gegenwart solcher Nebenprodukte im allgemeinen nicht gestört.

Als Beispiele für Glycidylgruppen enthaltende Verbindungen, die mit Acryl- oder Methacrylsäure und mit einer Anthracencarbonsäure der Formel V, einem phenolischen Hydroxyanthracen der Formel VI, einem Anthracenalkohol der Formel VII, einem Aminoanthracen der Formel VIII oder einer Anthracensulfonsäure der Formel IX behandelt werden können, seien Polyglycidylester genannt, die man durch Umsetzung einer Verbindung mit zwei oder mehr Carbonsäuregruppen pro Molekül mit Epichlorhydrin oder Glycerindichlorhydrin in Gegenwart von Alkali erhalten kann. Solche Polyglycidylester können sich von aliphatischen Polycarbonsäuren, z. B. Bernsteinsäure, Glutarsäure, Adipinsäure, Pimelinsäure, Korksäure, Azelainsäure, Sebacinsäure oder dimerisierter oder trimerisierter Linolsäure, von cycloaliphatischen Polycarbonsäuren wie Tetrahydrophthalsäure, 4-Methyltetrahydrophthalsäure, Hexahydrophthalsäure und 4-Methylhexahydrophthalsäure sowie von aromatischen Polycarbonsäuren wie Phthalsäure, Isophthalsäure und Terephthalsäure ableiten. Weitere geeignete Polyglycidylester sind durch Polymerisation von Glycidylestern von Vinylsäuren, insbesondere Glycidylacrylat und Glycidylmethacrylat, erhältlich.

Weitere Beispiele sind Polyglycidyläther, die durch Umsetzung einer mindestens zwei freie alkoholische und/oder phenolische Hydroxylgruppen pro Molekül enthaltenden Verbindung mit Epichlorhydrin unter alkalischen Bedingungen oder auch in Gegenwart eines sauren Katalysators mit nachfolgender Alkalibehandlung erhältlich sind. Diese Aether lassen sich mit Polyepichlorhydrinen aus acyclischen Alkoholen wie Aethylenglycol, Diäthylenglykol und höheren Poly-(oxyäthylen)-glykolen, Propan-1,2-diol und Poly-(oxypropylen)-glykolen, Propan-1,3-diol, Poly-(oxytetramethylen)-glykolen, Pentan-1,5-diol, Hexan-2,4,6-triol, Glycerin, 1,1,1-Trimethylolpropan, Pentaerythrit und Sorbit, aus cycloaliphatischen Alkoholen wie Resorcit, Chinit, Bis-(4-hydroxycyclohexyl)-methan, 2,2-Bis-(4-hydroxycyclohexyl)-propan und 1,1-Bis-(hydroxymethyl)-cyclohexen-3, und aus Alkoholen mit aromatischen Kernen, wie N,N-Bis-(2-hydroxyäthyl)-anilin und p,p'-Bis-(2-hydroxyäthylamino)-diphenylmethan herstellen. Man kann sie ferner aus einkernigen Phenolen, wie Resorcin und Hydrochinon, und mehrkernigen Phenolen wie Bis-(4-hydroxyphenyl)-methan (sonst als Bisphenol F bekannt), 4,4'-Dihydroxydiphenyl, Bis-(4-hydroxyphenyl)-sulfon, 1,1,2,2-Tetrakis-(4-hydroxyphenyl)-methan, 2,2-Bis-(4-hydroxyphenyl)-propan (sonst als Bisphenol A bekannt) und 2,2-Bis-(3,5-dibrom-4-hydroxyphenyl)-propan sowie aus Aldehyden wie Formaldehyd, Acetaldehyd, Chloral und Furfurol mit Phenol selbst und durch Chloratome oder Alkylgruppen mit jeweils bis zu neun Kohlenstoffatomen ringsubstituiertem Phenol wie 4-Chlorphenol, 2-Methylphenol und 4-tert.-Butylphenol gebildeten Novolaken erhalten.

Poly-(N-glycidyl)-verbindungen sind ebenfalls verwendbar, z. B. N-Glycidylderivate von Aminen wie Anilin, n-Butylamin, Bis-(4-aminophenyl)-methan und Bis-(4-methylaminophenyl)-methan, Triglycidylisocyanurat sowie N,N'-Diglycidylderivate von cyclischen Alkylenharnstoffen wie Aethylenharnstoff und 1,3-Propylenharnstoff und von Hydantoinen wie 5,5-Dimethylhydantoin.

Auch kann man Poly-(S-glycidyl)-verbindungen einsetzen, z. B. Di-(S-glycidyl)-derivate von Dithiolen wie Aethan-1,2-dithiol und Bis-(4-mercaptomethylphenyl)-äther, doch sind diese nicht bevorzugt.

In Betracht kommen auch Polyepoxide, in welchen die 1,2-Epoxidgruppen an Heteroatome verschiedener Art gebunden sind, beispielsweise der Glycidyläther/Glycidylester der Salicylsäure oder p-(Diglycidylamino)-phenylglycidyläther.

Gewünschtenfalls kann man ein Gemisch von Polyepoxiden einsetzen.

Besonders bevorzugt steht $R^4$ für einen zweiwertigen Rest eines gegebenenfalls vorverlängerten Polyglycidyläthers aus einem mehrwertigen Phenol oder einem mehrwertigen aliphatischen Alkohol.

Eine weitere Methode zur Herstellung von (A) besteht darin, dass man einen mehrwertigen Alkohol in beliebiger Reihenfolge mit (Meth)acryloylchlorid und einem Anthranoylchlorid der Formel

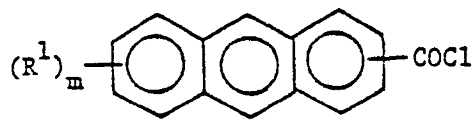 (XIII)

worin $R^1$ und m die unter Formel II angegebenen Bedeutungen haben, wie Anthracen-9-carbonsäurechlorid und Anthracen-2-carbonsäurechlorid, oder einem Isocyanatoanthracen der Formel

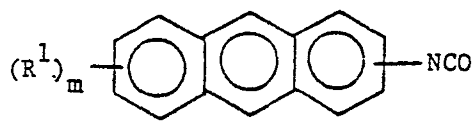 (XIV)

worin $R^1$ und m die unter Formel II angegebenen Bedeutungen haben, wie 2-Isocyanatoanthracen oder 9-Isocyanatoanthracen, umsetzt.

Dementsprechend kann man Verbindungen der Formel

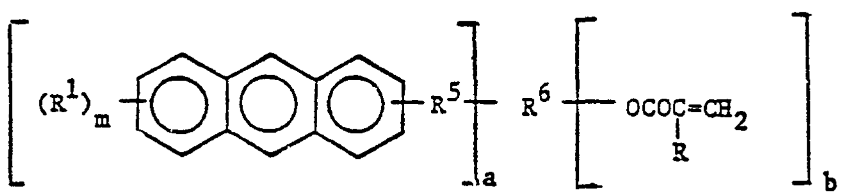 (XV)

worin R die unter Formel I, $R^1$ und m die unter Formel II sowie a und b die unter Formel X angegebenen Bedeutungen haben, $R^5$ eine Gruppe der Formel —COO— oder —NHCOO— und $R^6$ nach Wegnahme von (a + b) alkoholischen Hydroxylgruppen den Rest eines mindestens (a + b) solche Hydroxylgruppen enthaltenden mehrwertigen Alkohols darstellen, verwenden.

Vorzugsweise steht $R^6$ für einen wiederkehrende Einheiten der Formel $—(CH_2)_n—$, worin n 2, 3 oder 4 ist, oder der Formel $—CO(CH_2)_5—$, $—CH_2CH—$ oder $—CH_2(CH_3)CH_2—$ enthaltenden aliphatischen Rest. So kann $R^6$ beispielsweise für den Rest eines Polyoxyäthylenglykols oder Polyoxypropylenglykols vom Durchschnittsmolekurgewicht 250 bis 5 000 oder den Rest eines Polyvinylalkohols vom Durchschnittsmolekulargewicht 500 bis 9 000 stehen.

Es versteht sich, dass sich als Folge der Konkurrenz für die Reaktion mit den alkoholischen Hydroxylgruppen zwischen dem Anthranoylchlorid der Formel XIII oder Isocyanatoanthracen der Formel XIV einerseits und dem (Meth)acryloylchlorid andererseits dabei ebenfalls Nebenprodukte der Formel

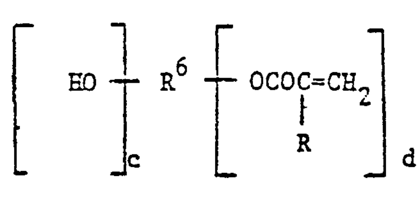 (XVI)

und der Formel

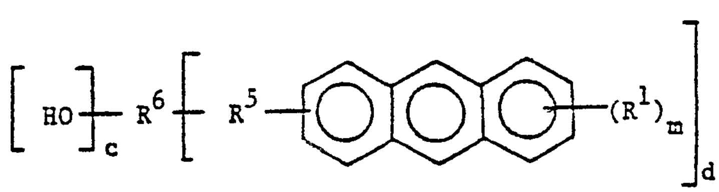 (XVII)

worin R die unter Formel I, $R^1$ und m die unter Formel II, $R^5$ und $R^6$ die unter Formel XV sowie c und d die unter Formeln XI und XII angegebenen Bedeutungen haben, bilden, wobei deren Anteile von den Mengenverhältnissen der eingesetzten Reaktionspartner abhängen ; sie stören jedoch nicht.

Methoden zur Umsetzung von Säurechloriden mit Alkoholen zur Bildung von Estern sowie von Isocyanaten mit Alkoholen zur Bildung von Urethanen sind wohlbekannt.

Mehrwertige Alkohole mit 3 oder mehr alkoholischen Hydroxylgruppen können durch Umsetzung mit einem anthracenhaltigen Aldehyd der Formel

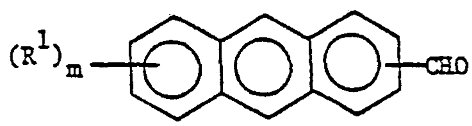

(XVIII)

worin $R^1$ und m die unter Formel II angegebenen Bedeutungen haben, wie Anthracen-9-aldehyd, Acetale bilden, wobei man gleichzeitig oder in beliebiger Reihenfolge die übrige(n) alkoholische(n) Hydroxylgruppe bzw. -gruppen durch Umsetzung mit (Meth)acryloylchlorid in (Meth)acryloyloxygruppen überführen kann.

Dementsprechend kann man als (A) Ester-acetale einsetzen, die im Molekül mindestens eine Gruppe der Formel

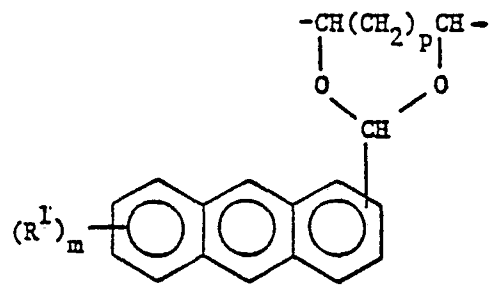

(XIX)

und mindestens eine Gruppe der Formel

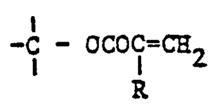

(XX)

worin R die unter Formel I sowie $R^1$ und m die unter Formel II angegebenen Bedeutungen haben und p null, 1, 2 oder 3 ist, enthalten.

Zweckmässig wird dabei die Verbindung von (A) aus einem Polyvinylalkohol vom Durchschnittsmolekulargewicht 500 bis 9 000 gebildet.

Es versteht sich, dass dabei ebenfalls Gruppen I und keine Gruppen II, oder umgekehrt, enthaltende Nebenprodukte gebildet werden können, doch stören diese das erfindungsgemässe Verfahren nicht.

Bei einem weiteren Weg zu als (A) verwendbaren Verbindungen werden Polyamine eingesetzt. Dabei bringt man in beliebiger Reihenfolge oder gleichzeitig ein Polyamin zur Reaktion mit (Meth)acryloylchlorid und einem Anthranoylchlorid der Formel XIII oder auch einem Isocyanatoanthracen der Formel XIV.

Somit kann man Amide der Formel

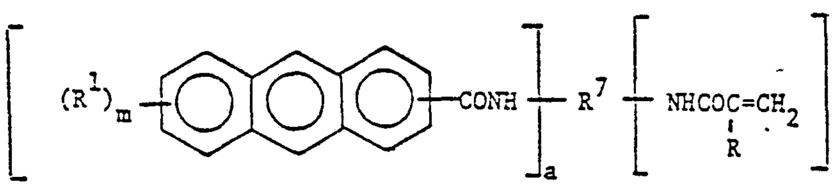

(XXI)

und Harnstoffamide der Formel

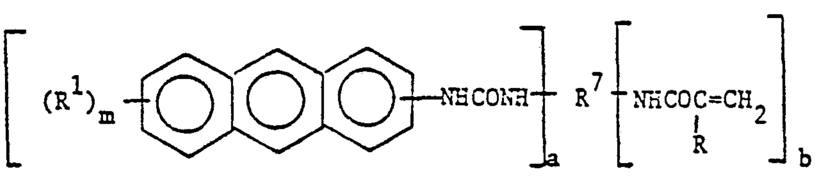

(XXII)

worin R die unter Formel I, $R^1$ und m die unter Formel II sowie a und b die unter Formel X angegebenen Bedeutungen haben und $R^7$ nach Wegnahme von (a + b) primären Aminogruppen den Rest einer mindestens (a + b) solche Aminogruppen enthaltenden Verbindungen darstellt, verwenden.

Dabei bilden sich ebenfalls Nebenprodukte, die jedoch nicht stören, der Formel

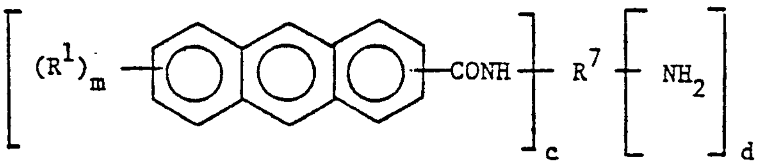

(XXIII)

oder

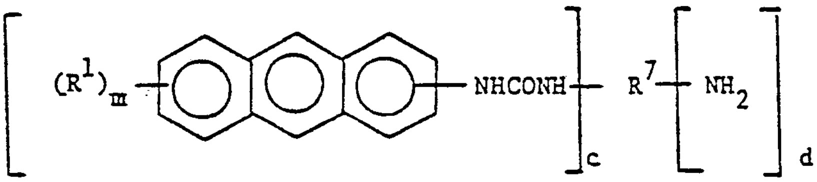

(XXIV)

und

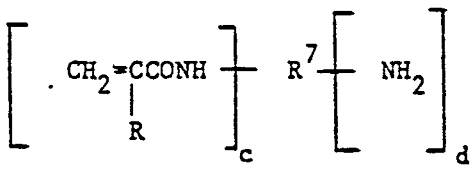

(XXV)

worin R die unter Formel I, $R^1$ und m die unter Formel II, $R^7$ die unter Formeln XXI und XXII sowie c und d die unter Formeln XI und XII angegebenen Bedeutungen haben.

Noch weitere zur Verwendung als (A) geeignete Verbindungen sind die durch Behandlung von 9-Anthrylmethylamin mit (Meth)acryloylchlorid erhältlichen Amide, d. h. Verbindungen der allgemeinen Formel

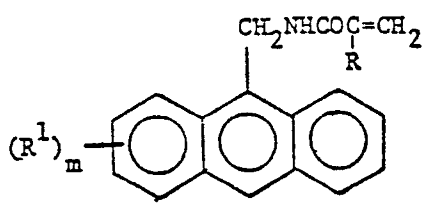

(XXVI)

worin R die unter Formel I sowie $R^1$ und m die unter Formel II angegebenen Bedeutungen haben.

9-Anthrylmethylamin kann man aus 9-Anthracenaldehyd durch Umsetzung mit Wasserstoff in Gegenwart von Ammoniak erhalten.

Bei anderen Wegen zur Herstellung von zur Verwendung als (A) geeigneten Verbindungen handelt es sich um die Umsetzung eines Hydroxyanthracens der Formel VI, eines anthracenhaltigen Alkohols der Formel VII oder eines Amino-anthracens der Formel VIII mit (Meth)acryloylchlorid. So kann man Ester der allgemeinen Formel

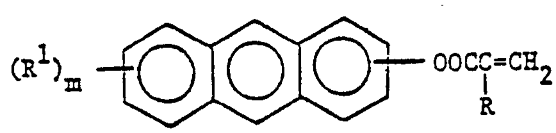

(XXVII)

oder

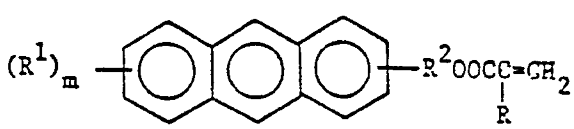

(XXVIII)

und Amide der allgemeinen Formel

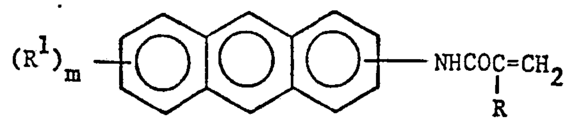

(XXIX)

worin R die unter Formel I, $R^1$ und m die unter Formel II und $R^2$ die unter Formel VII angegebenen Bedeutungen haben, verwenden.

Besonders bevorzugte Verbindungen (A) sind die durch Umsetzung einer Anthracencarbonsäure mit Glycidyl (meth)acrylate gebildeten Ester, d. h. solche der Formel

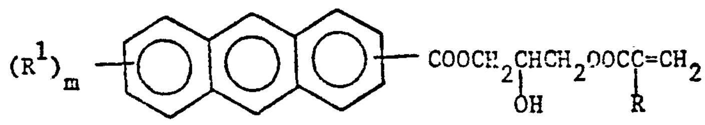

(XXX)

worin R die unter Formel I sowie $R^1$ und m die unter Formel II angegebenen Bedeutungen haben.

Verbindungen der Formel XXX lassen sich auch durch Umsetzung von Anthracencarbonsäureglycidylester mit (Meth)acrylsäure herstellen.

Anthracen-9-carbonsäure-3-(acryloyloxy)-2-hydroxypropylester, Anthracen-9-carbonsäure-3-(methacryloyloxy)-2-hydroxypropylester und 9-Anthrylmethylacrylat werden zur Verwendung als (A) besonders bevorzugt.

Es ist bei weitem vorzuziehen, dass die flüssige Zusammensetzung ferner einen zugesetzten Photoinitiator enthält, d. h. einen Katalysator, der bei Bestrahlung einen angeregten Zustand ergibt, der zur Bildung freier Radikale führt, die dann die Polymerisation von (A) einleiten. Beispiele für geeignete Photoinitiatoren sind organische Peroxyde und Hydroperoxyde, α-halogensubstituierte Acetophenone wie Trichlormethyl-4'-tert.-butylphenylketon, α-hydroxy-α-alkyl-substituierte Acetophenone wie 2-Hydroxy-2-methyl-1-phenylpropanon-1, Benzoin und dessen Alkyläther (z. B. der N-Butyläther), α-Methylbenzoin, α,α-Dialkoxy-α-benzoylessigsäurealkylester, Benzophenone wie Benzophenon selbst und 4,4'-Bis-(dimethylamino)-benzophenon, O-Alkoxycarbonylderivate eines Oxims des Benzils oder 1-Phenylpropan-1,2-dions, wie Benzil-(O-äthoxycarbonyl)-α-monoxim und 1-Phenylpropan-1,2-dion-2-(O-äthoxycarbonyl)-oxim, Benzilketale, z. B. dessen Dimethylketal, substituierte Thioxanthone, z. B. 2-Chlorthioxanthon, Anthrachinone, Ester der Phenylglyoxylsäure, 2-Benzoyl-2-phenyl-1,3-dioxolane und 4-Benzoyl-4-phenyl-1,3-dioxolane sowie Photoredoxsysteme, die aus einem Gemisch aus einem Phenothiazinfarbstoff (z. B. Methylenblau) oder einem Chinoxalin (z. B. einem Metallsalz der 2-(m- oder p-Methoxyphenyl)-chinoxalin-6'- oder -7'-sulfonsäure) mit einem Elektronendonator wie Benzolsulfinsäure oder einer anderen Sulfinsäure oder einem Salz davon, wie dem Natriumsalz, oder einem Arsin, einem Phosphin oder Thioharnstoff bestehen.

Geeignete Photoinitiatoren lassen sich leicht durch Serienversuche auffinden. Im allgemeinen werden 0,15 bis 10 Gew.-% und vorzugsweise 2,5 bis 5 Gew.-% Photoinitiator zugegeben, bezogen auf das Gesamtgewicht von (A) und gegebenenfalls einer weiteren Verbindung (B) mit mindestens einer Gruppe der Formel I aber keiner der Formel II. (Zur Verwendung als Verbindung (B) geeignete Substanzen sind weiter unten beschrieben.)

Bezugnahmen auf Photovernetzung über Gruppen der Formel II sind in dieser Patentschrift nicht so auszulegen, als dass sie die Möglichkeit ausschliessen würden, dass ein geringes Ausmass von Photodimerisierung über Gruppen der Formel II in der Stufe (1) stattfinden könnte ; es wird jedoch angenommen, dass die Photopolymerisation in Stufe (1) weit überwiegend nur Gruppen der Formel I betrifft.

Wie oben erwähnt, wird die Zusammensetzung in flüssiger Form auf einen Träger aufgebracht. Zweckmässig liegt ihre Viskosität im Bereich 0,1 bis 0,4 Pa.s. Um das Erfordernis einer flüssigen Zusammensetzung zu erfüllen, kann es nötig sein, um dies ohne Anwendung flüchtiger organischer Lösungsmittel zu erreichen, eine weitere Verbindung mitzuverwenden, die flüssig ist und unter den Bedingungen der Stufe (1) unter Bildung eines Feststoffs photopolymerisiert. Hierfür ist es bevorzugt, eine photopolymerisierbare Verbindung (B) mit mindestens einer Gruppe der Formel I aber keiner der Formel II im Molekül zu verwenden. Die Verbindung (B) kann beispielsweise ein gegebenenfalls im Alkyl- oder Hydroxyalkylteil substituierter Alkyl- oder Hydroxyalkylester der Acrylsäure oder Methacrylsäure sein, wobei solche Ester typischerweise insgesamt bis 15 Kohlenstoffatome aufweisen, wie Methylmethacrylat, Aethylmethacrylat, n-Butylacrylat und 2-Hydroxyäthylacrylat. Ebenfalls kommen hierfür die 3-Alkoxy-2-hydroxypropyl-, 3-Alkenoxy-2-hydroxypropyl- und 3-Aryloxy-2-hydroxypropylester der Acrylsäure oder Methacrylsäure in Betracht, wobei diese typischerweise insgesamt bis 15 Kohlenstoffatome enthalten.

Weitere Arten Verbindung (B) können der flüssigen Zusammensetzung zugegeben werden, um dem photopolymerisierten, photovernetzten Produkt gewisse gewünschte Eigenschaften zu verleihen. So

kann die Verbindung (B) auch mindestens ein Chlor-, Brom- oder Phosphoratom enthalten, um flammhemmende Eigenschaften zu verleihen. Beispiele dafür sind Acrylsäure- oder Methacrylsäureaddukte mit einem brom- oder chlorsubstituierten Arylglycidyläther wie Dibrom-p-kresyl-glycidyläther, z. B. 3-(Methacryloyloxy)-2-hydroxypropyl-X,Y-dibrom-p-kresyläther.

Wie unten erläutert, kann es wünschenswert sein, Epoxidgruppen in die Zusammensetzung einzuführen, denn nach der Photovernetzung der Produkts lässt sich weitere Vernetzung durch Heisshärtung über die Epoxidgruppen erzielen. Es kann daher vorteilhaft sein, in der flüssigen Zusammensetzung eine photopolymerisierbare Verbindung mitzuverwenden, die im selben Molekül sowohl eine Gruppe der Formel I und nur eine 1,2-Epoxidgruppe aufweist, wie Glycidylacrylat oder Glycidylmethacrylat. Ferner kann man den flüssigen Zusammensetzungen vor der Photopolymerisation ein Epoxidharz (d. h. eine mehr als eine Epoxidgruppe enthaltende Verbindung) zufügen.

Gewünschtenfalls kann die flüssige Zusammensetzung ebenfalls eine photopolymerisierbare Verbindung (C) mit mindestens einer Gruppe der Formel II aber keiner der Formel I enthalten, z. B. 1-(2-Anthryl)-äthanol.

Die flüssige Zusammensetzung lässt sich nach herkömmlichen Methoden wie Sprühbeschichtung, Aufschleudern, Walzenauftrag, Kaskadenbeschichtung und insbesondere Vorhangbeschichtung auf geeignete Träger aufbringen. Typischerweise wird der Träger so beschichtet, dass die Schicht der Zusammensetzung 1 bis 250 µm dick ist. Der Träger kann beispielsweise aus Kupfer, Aluminium oder einem anderen Metall, aus Papier, Kunstharz oder Glas bestehen.

Sowohl bei der Photopolymerisationsstufe als auch der nachfolgenden Photovernetzungsstufe des erfindungsgemässen Verfahrens verwendet man vorzugsweise aktinische Strahlung einer Wellenlänge von 200-600 nm. Als aktinische Strahlungsquellen eignen sich unter anderem Kohlelichtbögen, Quecksilberdampflichtbögen, Leuchtröhren mit utraviolettes Licht ausstrahlenden Leuchtstoffe, Argon- und Xenonglimmlampen, Wolframlampen und photographische Flutlampen. Darunter sind Quecksilberdampflichtbögen, insbesondere Höhensonnen, fluoreszierende Höhensonnen und Metallhalogenidlampen am besten geeignet. Die zur Belichtung der photopolymerisierbaren Zusammensetzung und der noch photovernetzbaren Zusammensetzung erforderliche Zeit hängt von verschiedenen Faktoren ab, beispielsweise den individuellen verwendeten Verbindungen, der Art der Lichtquelle und deren Abstand von der bestrahlten Zusammensetzung. Der mit Photopolymerisationsmethoden vertraute Fachmann kann die geeigneten Zeiten leicht bestimmen ; im allgemeinen ist die in der zweiten Stufe (der Photovernetzungsstufe) benötigte Lichtenergiemenge 15- bis 100 mal, typischerweise 25- bis 60 mal, grösser als in der ersten Stufe. Zum Beispiel wird die Zusammensetzung zunächst in 10-25 cm Abstand von der Strahlenquelle 5-15 Sekunden lang mit einer 500 Watt-Birne bestrahlt ; in der zweiten Stufe wird sie 10-20 Minuten lang im Abstand von 15-30 cm bestrahlt. Mit stärkeren Strahlungsquellen, z. B. 5 Kilowatt, können die Bestrahlungszeiten, besonders in der zweiten Stufe, viel kürzer sein.

Die zur Verwendung als Verbindung (A) bevorzugten Substanzen enthalten nur eine Gruppe der Formel I pro Molekül, doch wurden befriedigende Ergebnisse mit mehr als eine solche Gruppe enthaltenden Substanzen erzielt. Bei Verwendung von Diacrylaten, Dimethacrylaten und anderen mehr als eine Gruppe der Formel I enthaltenden Substanzen soll die Belichtung mit aktinischer Strahlung in Stufe (1) begrenzt sein, damit eventuelle Vernetzung über Gruppen der Formel I in dieser Stufe nicht so weit fortschreitet, dass die Erzeugung einer Abbildung in Stufe (3) erheblich gehemmt wird.

Zum Entwickeln der Abbildung geeignete Lösungsmittel lassen sich leicht durch Serienversuche auffinden ; dies sind unter anderem Cyclohexanon, Trimethylcyclohexanon, Aceton, Toluol, 2-Aethoxyäthanol, 1,1,1-Trichloräthan, Methylenchlorid und deren Gemische. Es kann notwendig sein, die Wirkung des Lösungsmittels durch Rühren oder leichtes Bürsten zu unterstützen. Besitzt der Träger eine Schicht eines geeigneten elektrisch leitenden Metalls, üblicherweise Kupfer oder Silber, in direkter Berührung mit der photopolymerisierten Zusammensetzung, so kann das unvernetzte Polymer durch Entwicklung entfernt werden, um das Metall freizulegen. So freigelegtes Metall kann dann an den Nicht-bildstellen mittels Aetzflüssigkeiten wie Ferrichlorid- oder Ammoniumpersulfatlösung weggeätzt werden, um eine gedruckte Schaltung zu bilden.

Gewünschtenfalls kann man in der flüssigen Zusammensetzung eine Verbindung (B) mitverwenden, welche mindestens eine freie Sulfon- oder Phosphorsäuregruppe oder insbesondere mindestens eine freie Carboxylgruppe aufweist ; zweckmässig ist dies Acrylsäure oder Methacrylsäure oder ein Anlagerungsprodukt eines Hydroxyalkylacrylats oder -methacrylats mit Trimellithsäureanhydrid, d. h. eine Verbindung der Formel

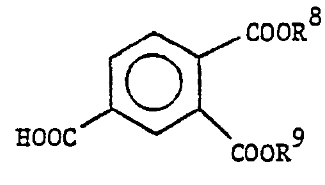

(XXXI)

worin $R^8$ entweder ein Wasserstoffatom bedeutet, in welchem Fall $R^9$ dann eine Gruppe der Formel

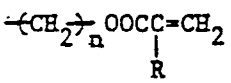 (XXXII)

oder

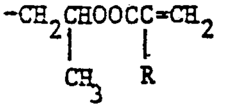 (XXXIII)

darstellt, oder $R^8$ bedeutet eine Gruppe der Formel XXXII oder XXXIII, in welchem Fall $R^9$ dann ein Wasserstoffatom darstellt, wobei R die unter Formel I angegebene Bedeutung hat und n 2, 3 oder 4 ist.

Die Gegenwart freier Sulfon-, Phosphor- oder Carbonsäuregruppen im photopolymerisierten Polymer hat zur Folge, dass man zur Entwicklung eine wässrige Lösung einer Base, wie verdünnte Natronlauge, Natriumcarbonat-, Dinatriumhydrogenorthophosphat- oder Ammoniaklösungen verwenden kann, wodurch die Anwendung organischer Lösungsmittel in dieser Stufe vermieden wird.

Andererseits kann man in der flüssigen Zusammensetzung auch eine Verbindung (B) mitverwenden, welch auch mindestens eine primäre, sekundäre oder tertiäre Aminogruppe trägt. Als Folge der Gegenwart freier Aminogruppen im photopolymerisierten Polymer kann man wässrige Säurelösungen, wie verdünnte Mineralsäurelösungen, als Entwickler einsetzen. Beispiele für solche Verbindungen (B) sind Alkylester der Acryl- oder Methacrylsäure, deren Alkylgruppen durch eine sekundäre oder tertiäre Aminogruppe substituiert sind, wie 2-(Dimethylamino)-äthyl-methacrylat.

Wie bereits angegeben kann die Zusammensetzung nach der Photopolymerisation und Photovernetzung ein Epoxidharz enthalten, wobei sie dann ferner einen latenten Heisshärter für das Epoxidharz enhalten kann, so dass die Zusammensetzung erhitzt werden und zusätzliche Vernetzung eintreten kann, um die Beständigkeit des photovernetzten Produkts gegen Lösungsmittel und hohe Temperaturen weiter zu erhöhen. Wie schon angegeben kann das Epoxidharz als solches in die Zusammensetzung eingearbeitet oder an Ort und Stelle durch Photopolymerisation einer zusätzlich nur eine 1,2-Epoxidgruppe im Molekül enthaltenden Verbindung (B) gebildet werden. Latente Heisshärter für Epoxidharze sind beispielsweise Polycarbonsäureanhydride wie Hexahydrophthalsäureanhydrid, Dicyandiamid, Bortrifluorid- oder Bortrichloridkomplexe von Aminen wie Aethylamin, Trimethylamin und n-Octyldimethylamin, latente Bordifluoridchelate, aromatische Polyamine wie Bis-(p-aminophenyl)-methan und Bis-(p-aminophenyl)-sulfon, aromatische Biguanide wie 2,6-Xylidenbiguanid und Imidazole wie 2-Aethyl-4-methylimidazol oder 2-Phenylimidazol.

Die nachfolgenden Beispiele erläutern die Erfindung. Falls nicht anders angegeben, sind Teile und Prozentangaben Gewichtsteile und Gewichtsprozente. Die in den Beispielen verwendeten Substanzen werden wie folgt hergestellt:

Anthracen-9-carbonsäure-3-(Methacryloyloxy)-2-hydroxypropylester

Man gibt Anthracen-9-carbonsäure (50 g) unter Rühren im Verlauf von 30 Minuten zu Glycidylmethacrylat (33,9 g, Epoxidgehalt 6,6 val/kg), das 0,13 g 2,6-Di-tert.-butyl-p-kresol und 0,25 g Tetramethylammoniumchlorid enthält, erhitzt auf 100 °C und dann noch weitere 4 Stunden bei 100 °C, wonach der Epoxidgehalt des Gemischs auf einen vernachlässigbar kleinen Wert gefallen ist. Das entstandene Produkt ist ein brauner, glasartiger Feststoff.

2-{p-[3-(Methacryloyloxy)-2-hydroxypropyl]-phenyl}-2-{p'-[3-(anthracen-9-carbonyloxy)-2-hydroxypropyl]-phenyl}-propan

Man tropft Methacrylsäure (12 g) unter Rühren im Verlauf von 1 1/2 Stunden zu einem auf 100 °C erhitzten Gemisch aus dem Diglycidyläther von 2,2-Bis-(p-hydroxyphenyl)-propan (50 g), der 0,15 g Tetramethylammoniumchlorid enthält, und 0,1 g 2,6-Di-tert.-butyl-p-kresol. Nach 1 1/2 Stunden Weiterrühren bei 100 °C gibt man im Verlauf von 1 Stunde und 10 Minuten portionsweise Anthracen-9-carbonsäure (31 g) dazu. Nach weiteren 3 Stunden Rühren des Gemischs ist dessen Epoxidgehalt vernachlässigbar.

Das wie erhalten verwendete Produkt besteht aus der obigen Verbindung zusammen mit den Nebenprodukten 2,2-Bis-{p-[3-(methacryloyloxy)-2-hydroxypropyl]-phenyl}-propan und 2,2-Bis-{p-[3-anthracen-9-carbonyloxy)-2-hydroxypropyl]-phenyl}-propan.

9-Anthrylmethyl-acrylat

Man kühlt ein 0,05 g 2,6-Di-tert.-butyl-p-kresol enthaltendes Gemisch aus 9-Hydroxymethylanthracen (20,8 g, 0,1 Mol) und Triäthylamin (11,1 g, 0,11 Mol) in 200 ml frischdestilliertem Diäthyläther unter Rühren auf 0 °C und hält die Temperatur des Gemischs auf etwa dieser Höhe, während man Acryloylchlorid (9,32 g, 0,103 Mol) dazugibt. Dann erwärmt man zum Rückfluss und erhitzt 2 Stunden unter Rückfluss. Nach Abkühlung des Gemischs werden 200 ml Wasser zugesetzt und die zwei Schichten geschieden. Die organische Schicht wird mit zweimal je 50 ml kalter 10 %iger Schwefelsäure und dann mit gesättigter

wässriger Natriumbicarbonatlösung gewaschen, während man die wässrige saure Schicht mit Dichlormethan weiter extrahiert und die organische Schicht mit gesättigter wässriger Natriumbicarbonatlösung wäscht. Schliesslich werden die beiden organischen Lösungen vereinigt und über wasserfreiem Magnesiumsulfat getrocknet und die Lösungsmittel abdestilliert. Es verbleiben 11,1 g der Titelverbindung als gelbes, halbkristallines Oel. Dieses erstarrt beim Stehen und besitzt dann einen Schmelzpunkt von 120-125 °C.

3-(Methacryloyloxy)-2-hydroxypropyl-X,Y-dibrom-p-kresyläther

Man versetzt 250 g handelsüblichen X,Y-Dibrom-p-kresyl-glycidyläther (Epoxidgehalt 2,76 val/kg, berechnet 3,11) mit 2,6-Di-tert.-butyl-p-kresol (0,5 g) und 1 g Tetramethylammoniumchlorid und erhitzt die Lösung unter Rühren auf 100 °C. Dann gibt man im Verlauf von 1 Stunde Methacrylsäure (59,34 g) langsam mit einer solchen Geschwindigkeit zu, dass die Temperatur des Gemischs 105 °C nicht übersteigt. Man erhitzt bei 100 °C weiter, bis der Epoxidgehalt auf einen vernachlässigbar kleinen Wert gefallen ist. Das Produkt ist eine klare, viskose Flüssigkeit.

Beispiel 1

Ein Gemisch aus 27,5 Teilen Glycidylmethacrylat, 67,5 Teilen Anthracen-9-carbonsäure-3-(methacryloyloxy)-2-hydroxypropylester und 5 Teilen Benzildimethylketal mit einer Viskosität von 0,2-0,3 Pa.s wird mittels eines Schleuderauftragsgeräts als ungefähr 20 µm dicke Schicht auf eine Kupferplatte aufgebracht. Man bestrahlt den Film 7 Sekunden mit einer Lampe (80 W pro cm) im Abstand von 20 cm, wobei er klebfrei wird. Danach bestrahlt man durch eine Vorlage hindurch im Abstand von 25 cm 15 Minuten lang mit einer 30 W/cm-Lampe. Die Abbildung wird durch Bewegen in Cyclohexanon/1,1,1-Trichloräthan (1 : 1 Vol./Vol.) entwickelt, wobei man eine gute Reliefabbildung erhält.

Beispiel 2

Man verfährt wie in Beispiel 1, jedoch unter Ersatz des Glycidylmethacrylats durch 27,5 Teile 2-Hydroxyäthylacrylat. Man erhält ebenfalls eine gute Reliefabbildung.

Beispiel 3

Man bestrahlt ein Gemisch aus 5 Teilen Glycidylmethacrylat, 45 Teilen 3-(Methacryloyloxy)-2-hydroxypropyl-X,Y-dibrom-p-kresyläther, 45 Teilen Anthracen-9-carbonsäure-3'-(methacryloyloxy)-2'-hydroxypropylester und 5 Teilen Benzildimethylketal nacheinander unter den in Beispiel 1 angewandten Bedingungen. Beim Entwickeln erhält man ebenfalls eine gute Reliefabbildung.

Beispiel 4

In diesem Beispiel wird ein latenter Heisshärter für Epoxidharze, nämlich Bortrichlorid/Trimethylaminkomplex mitverwendet, um Heisshärtung des durch Photopolymerisation von Glycidylmethacrylat an Ort und Stelle gebildeten Epoxidharzes zu bewirken.

Eine Formulierung, die aus 50 Teilen des wie oben beschrieben hergestellten, 2'-[p-(3-Methacryloyloxy)-2-hydroxypropyl]-2-{p'-[3-(anthracen-9-carbonyloxy)-2-hydroxypropyl]-phenyl}-propan enthaltenden Gemischs, 30 Teilen 3-(Methacryloyloxy)-2-hydroxypropyl-X,Y-dibrom-p-kresyläther, 20 Teilen Glycidylmethacrylat, 4 Teilen Benzildimethylketal und 4 Teilen Bortrichlorid/Trimethylaminkomplex besteht, wird als 10 µm dicke Beschichtung auf einen kupferkaschierten Schichtkörper aufgebracht und 10 Sekunden im Abstand von 20 cm unter einer Mitteldruckquecksilberlampe (80 W pro cm) bestrahlt. Man erhält eine klebfreie Beschichtung. Danach legt man ein Negativ auf die Beschichtung und bestrahlt die Probe 20 Minuten im Abstand von 25 cm mit einer 30 W/cm-Mitteldruckquecksilberlampe. Entwickeln in Toluol ergibt eine gute Abbildung, die 10-maligem Reiben mit einem in Aceton getränkten Wattebausch widersteht. Nach 1 Stunde Erhitzen auf 140 °C ist die Lösungsmittelbeständigkeit weiter erhöht, wobei 20-maliges solches Reiben kaum eine Wirkung auf die Abbildung hat.

Beispiel 5

Man bringt ein Gemisch aus 50 Teilen 9-Anthryl-methyl-acrylat, 25 Teilen Glycidylacrylat und 6 Teilen Benzildimethylketal auf eine Kupferplatte auf und bestrahlt nacheinander unter den in Beispiel 1 angewandten Bedingungen, ausser dass die Bestrahlung in der ersten Stufe 30 Sekunden dauert. Beim Entwickeln mit 1,1,1-Trichloräthan erhält man eine Abbildung.

Vergleichsbeispiel

Nur zu Vergleichszwecken wird ein Gemisch aus 66 Teilen 9-Hydroxymethylanthracen, 33 Teilen

Allylacrylat und 8 Teilen Benzyldimethylketal als Schicht aufgebracht und wie in Beispiel 1 beschrieben bestrahlt, wobei es aber erforderlich ist, in der ersten Stufe 30 Sekunden lang zu bestrahlen, um eine klebfreie Beschichtung zu erhalten. Weitere Bestrahlung durch ein photographisches Negativ hindurch ergibt jedoch keine weitere Vernetzung, da sich der ganze Film auflöst, wenn man versucht, mit Cyclohexanon eine Abbildung zu entwickeln.

**Patentansprüche**

1. Verfahren zur Erzeugung einer Abbildung, dadurch gekennzeichnet, dass man

(1) eine auf einem Träger aufgebrachte Schicht aus einer flüssigen Zusammensetzung, die eine Verbindung (A) mit sowohl mindestens einer Gruppe der Formel

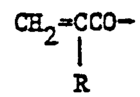

(I)

als auch mindestens einer Gruppe der Formel

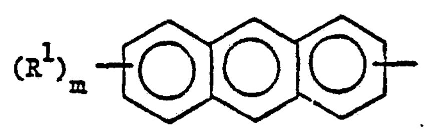

(II)

im selben Molekül enthält, wobei R ein Wasserstoffatom oder eine Methylgruppe bedeutet, $R^1$ ein Chlor- oder Bromatom, eine Methylgruppe oder eine Nitrogruppe darstellt und m null, 1 oder 2 ist, so mit aktinischer Strahlung belichtet, dass sich die Schicht durch Photopolymerisation von (A) über die Gruppe bzw. Gruppen der Formel I verfestigt und im wesentlichen klebfrei wird, jedoch weitgehend photovernetzbar bleibt, und anschliessend

(2) die so verfestigte Schicht durch eine bildtragende Vorlage mit weitgehend undurchsichtigen und weitgehend durchsichtigen Stellen hindurch mit einer wesentlich grösseren Menge aktinischer Strahlung belichtet, so dass die weiterbelichtete(n) Stelle(n) der photopolymerisierten Schicht über die Gruppe bzw. Gruppen der Formel II Photovernetzung eingehen, und

(3) die Abbildung durch Auflösung der nichtphotovernetzten Stelle der Schicht in einem Lösungsmitel entwickelt.

2. Verfahren nach Anspruch 1, dadurch gekennzeichnet, das (A) pro Durchschnittsmolekül bis zu vier Gruppen der Formel I enthält.

3. Verfähren nach Anspruch 1 oder 2, dadurch gekennzeichnet, dass (A) pro Durchschnittsmolekül bis zu vier Gruppen der Formel II enthält.

4. Verfahren nach einem der vorhergehenden Ansprüche, dadurch gekennzeichnet, dass die Gruppe(n) der Formel I direkt an ein Kohlenstoff-, Sauerstoff- oder Stickstoffatom bzw. -atome gebunden ist bzw. sind.

5. Verfahren nach einem der vorhergehenden Ansprüche, dadurch gekennzeichnet, das die Gruppe(n) der Formel II direkt an ein Kohlenstoff-, Sauerstoff- oder Stickstoffatom bzw. -atome gebunden ist bzw. sind.

6. Verfahren nach einem der Ansprüche 1 bis 3, dadurch gekennzeichnet, dass (A) der Formel

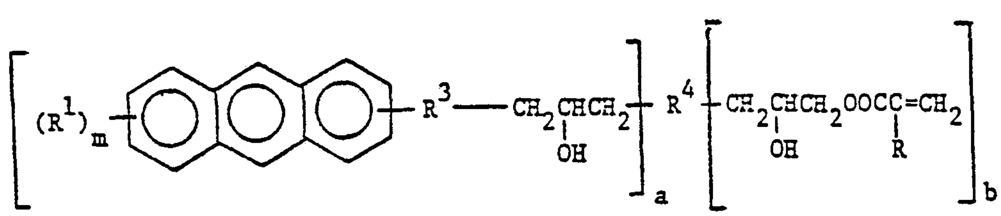

(X)

entspricht, worin a und b unabhängig voneinander eine ganze Zahl von mindestens 1 sind, R, $R^1$ und m die in Anspruch 1 angegebenen Bedeutungen haben, $R^3$ ein Gruppe der Formel —COO—, —O—, —$R^2$O—, —NH— oder —$SO_3$— darstellt, wobei $R^2$ für eine Alkylen- oder Alkylidengruppe mit 1 bis 4 Kohlenstoffatomen steht, und $R^4$ nach Wegnahme von (a + b) direkt an ein Sauerstoff-, Stickstoff- oder Schwefelatom gebundenen Glycidylgruppen den Rest einer mindestens (a + b) solche Glycidylgruppen enthaltenden Verbindung bedeutet.

7. Verfahren nach einem der Ansprüche 1 bis 3, dadurch gekennzeichnet, dass (A) der Formel

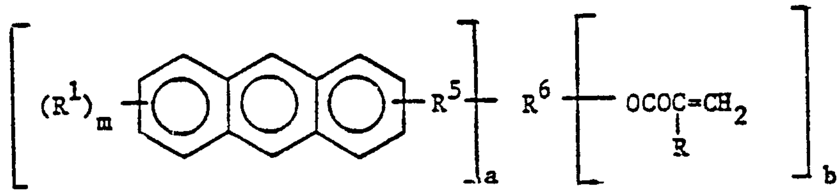

(XV)

entspricht, worin a und b je die in Anspruch 6 sowie R, $R^1$ und m die in Anspruch 1 angegebenen Bedeutungen haben, $R^5$ eine Gruppe der Formel —COO— oder —NHCOO— darstellt und $R^6$ nach Wegnahme von (a + b) alkoholischen Hydroxylgruppen den Rest einer mindestens (a + b) solche Hydroxylgruppen enthaltenden Verbindung bedeutet.

8. Verfahren nach einem der Ansprüche 1 bis 3, dadurch gekennzeichnet, dass als (A) ein Esteracetal vorliegt, das im Molekül mindestens eine Gruppe der Formel

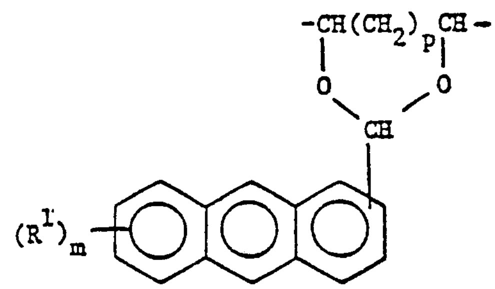

(XIX)

und mindestens eine Gruppe der Formel

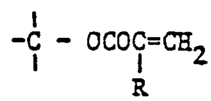

(XX)

enthält, worin R, $R^1$ und m die in Anspruch 1 angegebenen Bedeutungen haben und p null, 1, 2 oder 3 ist.

9. Verfahren nach einem der Ansprüche 1 bis 3, dadurch gekennzeichnet, dass als (A) ein Amid der Formel

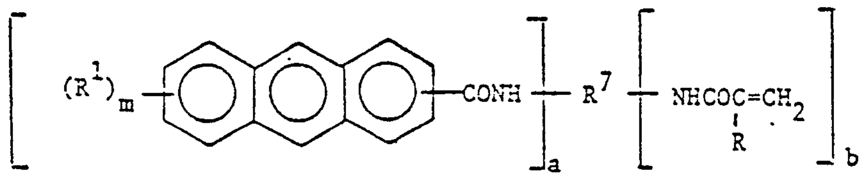

(XXI)

oder ein Harnstoff-amid der Formel

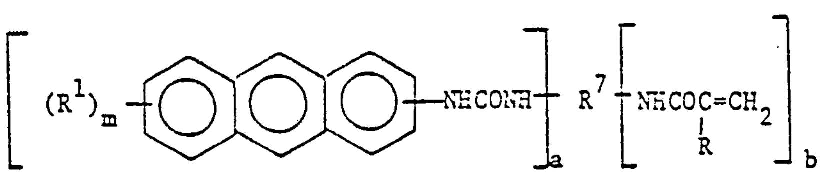

(XXII)

vorliegt, worin R, $R^1$ und m die in Anspruch 1 sowie a und b die in Anspruch 6 angegebenen Bedeutungen haben und $R^7$ nach Wegnahme von (a + b) primären Aminogruppen den Rest einer mindestens (a + b) solche Aminogruppen enthaltenden Verbindung darstellt.

10. Verfahren nach Anspruch 1, dadurch gekennzeichnet, dass (A) der allgemeinen Formel

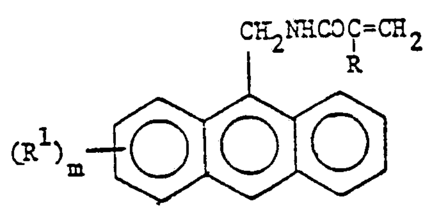

(XXVI)

entspricht, worin R, $R^1$ und m die in Anspruch 1 angegebenen Bedeutungen haben.

11. Verfahren nach Anspruch 1, dadurch gekennzeichnet, dass (A) der allgemeinen Formel

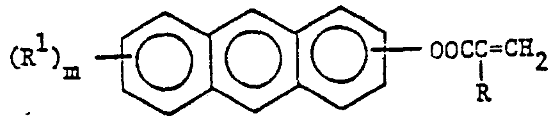

(XXVII)

entspricht, worin R, $R^1$ und m die in Anspruch 1 angegebenen Bedeutungen haben.

12. Verfahren nach Anspruch 1, dadurch gekennzeichnet, dass (A) der allgemeinen Formel

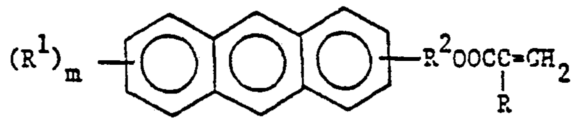

(XXVIII)

entspricht, worin R, $R^1$ und m die in Anspruch 1 und $R^2$ die in Anspruch 6 angegebenen Bedeutungen haben.

13. Verfahren nach Anspruch 1, dadurch gekennzeichnet, dass (A) der allgemeinen Formel

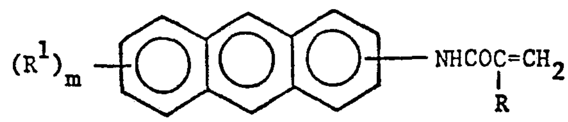

(XXIX)

entspricht, worin R, $R^1$ und m die in Anspruch 1 angegebenen Bedeutungen haben.

14. Verfahren nach Anspruch 1, dadurch gekennzeichnet, dass als (A) ein Ester der Formel

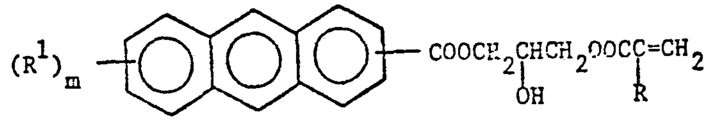

(XXX)

vorliegt, worin R, $R^1$ und m die in Anspruch 1 angegebenen Bedeutungen haben.

15. Verfahren nach einem der Ansprüche 1 bis 9 und 11 bis 14, dadurch gekennzeichnet, dass als Gruppe bzw. Gruppen der Formel II eine 1-Anthryl-, 2-Anthryl- oder 9-Anthrylgruppe bzw. -gruppen vorliegen.

16. Verfahren nach Anspruch 1, dadurch gekennzeichnet, dass als (A) Anthracen-9-carbonsäure-3-(acryloyloxy)-2-hydroxypropylester, Anthracen-9-carbonsäure-3-(methacryloyloxy)-2-hydroxypropylester oder 9-Anthrylmethyl-acrylat vorliegt.

17. Verfahren nach einem der vorhergehenden Ansprüche, dadurch gekennzeichnet, dass die Zusammensetzung zusätzlich eine photopolymerisierbare Verbindung (B) mit mindestens einer Gruppe der Formel I aber keiner der Formel II sowie mindestens einer freien Sulfon-, Phosphon- oder Carbonsäuregruppe im Molekül enthält und das verwendete Lösungsmittel eine wässrige Lösung einer Base ist.

18. Verfahren nach einem der Ansprüche 1 bis 16, dadurch gekennzeichnet, dass die Zusammensetzung eine photopolymerisierbare Verbindung (B) mit mindestens einer Gruppe der Formel I aber keiner der Formel II sowie mindestens einer primären, sekundären oder tertiären Aminogruppe im Molekül enthält und das verwendete Lösungsmittel eine wässrige Lösung einer Säure ist.

**Claims**

1. A process for production of an image which comprises

(1) exposing to actinic radiation a layer, supported on a carrier, of a liquid composition containing a compound (A) having in the same molecule both at least one group of formula

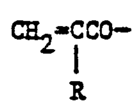

(I)

and at least one group of formula

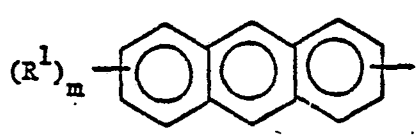

(II)

where R denotes a hydrogen atom or a methyl group, $R^1$ denotes a chlorine or bromine atom, a methyl group, or a nitro group, and m is zero, 1, or 2, such that the layer solidifies and becomes essentially nontacky due to photopolymerisation of (A) through the group or groups of formula I but remains substantially photocrosslinkable, and subsequently, when desired,

(2) exposing the layer so solidified through an imagebearing transparency consisting of substantially opaque and substantially transparent parts to a substantially greater amount of actinic radiation such that the further exposed part or parts of the photopolymerised layer undergo photocrosslinking through the group or groups of formula II, and

(3) developing the image by dissolving in a solvent the part or parts of the layer which have not become photocrosslinked.

2. A process according to claim 1, in which (A) contains, per average molecule, up to four groups of formula I.

3. A process according to claim 1 or 2, in which (A) contains, per average molecule, up to four groups of formula II.

4. A process according to any preceding claim, in which the group or groups of formula I is or are directly attached to an atom or atoms of carbon, oxygen, or nitrogen.

5. A process according to any preceding claim, in which the group or groups of formula II is or are directly attached to an atom or atoms of carbon, oxygen, or nitrogen.

6. A process according to any of claims 1 to 3, in which (A) is of the formula

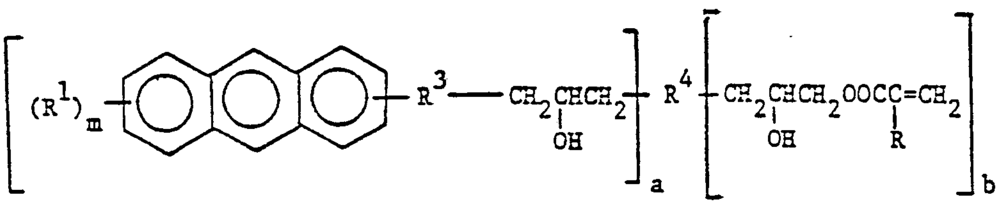

(X)

a and b are each independently an integer of at least 1, R, $R^1$, and m have the meaning assigned in claim 1, $R^3$ denotes a group of formula —COO—, —O—, —$R^2$O—, —NH—, or —$SO_3$—, where $R^2$ represents an alkylene or alkylidene group of 1 to 4 carbon atoms, and $R^4$ denotes the residue, after removal of (a + b) glycidyl groups directly attached to an atom or atoms of oxygen, nitrogen, or sulphur, of a compound containing at least (a + b) such glycidyl groups.

7. A process according to any of claims 1 to 3, in which (A) is of the formula

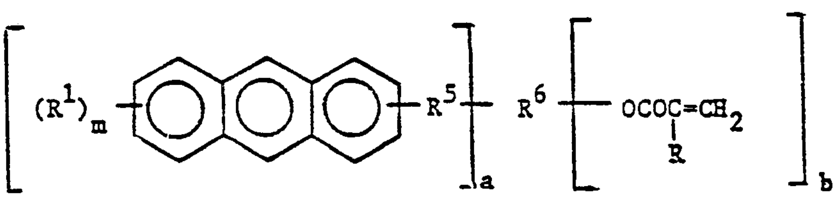

(XV)

a and b each have the meaning assigned in claim 6, R, $R^1$, and m have the meaning assigned in claim 1, $R^5$ denotes a group of formula —COO— or —NHCOO—, and $R^6$ denotes the residue, after removal of (a + b) alcoholic hydroxyl groups, of a compound containing at least (a + b) such hydroxyl groups.

8. A process according to any of claims 1 to 3, in which (A) is an ester-acetal containing in the molecule at least one group of formula

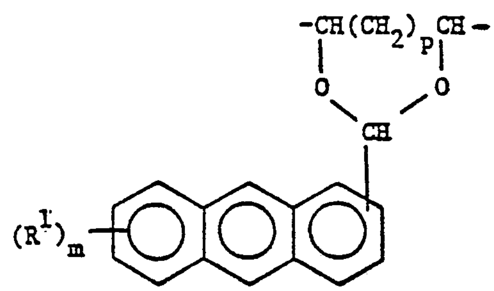

(XIX)

and at least one group of the formula

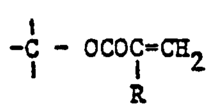

(XX)

where R, $R^1$, and m have the meaning assigned in claim 1 and p denotes zero, 1, 2, or 3.

9. A process according to any of claims 1 to 3, in which (A) is an amide of formula

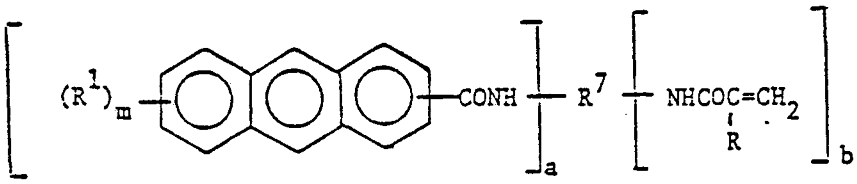

(XXI)

or a urea-amide of formula

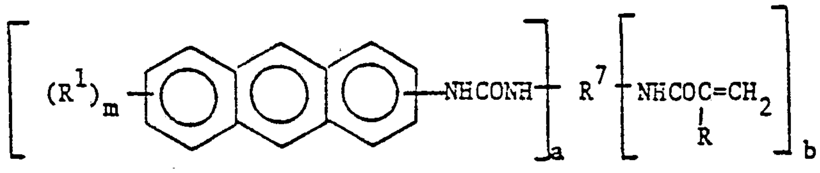

(XXII)

where R, $R^1$, and m have the meaning assigned in claim 1, a and b each have the meanings assigned in claim 6, and $R^7$ denotes the residue, after removal of (a + b) primary amino groups, of a compound containing at least (a + b) such amino groups.

10. A process according to claim 1, in which (A) is of the general formula

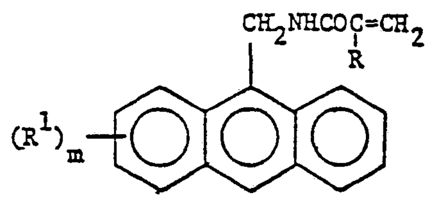

(XXVI)

where R, $R^1$, and m have the meanings assigned in claim 1.

11. A process according to claim 1, in which (A) is of the general formula

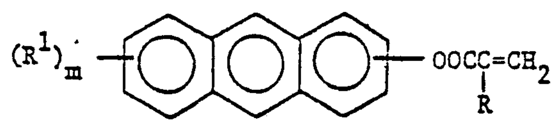

(XXVII)

where R, $R^1$, and m have the meanings assigned in claim 1.

12. A process according to claim 1, in which (A) is of the general formula

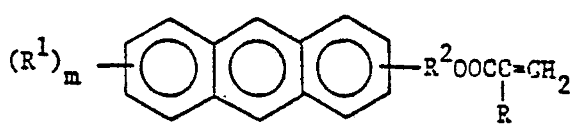

(XXVIII)

where R, $R^1$, and m have the meanings assigned in claim 1 and $R^2$ has the meaning assigned in claim 6.

13. A process according to claim 1, in which (A) is of the general formula

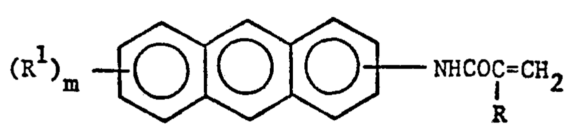

(XXIX)

where R, $R^1$, and m have the meaning assigned in claim 1.

14. A process according to claim 1, in which (A) is an ester of the formula

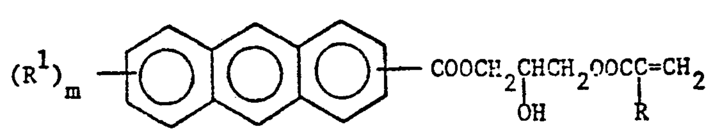

(XXX)

where R, $R^1$, and m have the meaning assigned in claim 1.

15. A process according to any of claims 1 to 9 and 11 to 14, in which the group or groups of formula II is or are a 1-anthryl, 2-anthryl, or 9-anthryl group or groups.

16. A process according to claim 1, in which (A) is 3-(acryloyloxy)-2-hydroxypropyl anthracene-9-carboxylate, 3-(methacryloyloxy)-2-hydroxypropyl anthracene-9-carboxylate, or 9-anthrylmethyl acrylate.

17. A process according to any preceding claim, in which the composition further contains a photopolymerisable compound (B) having in the molecule at least one group of formula I but none of formula II and also at least one free sulphonic, phosphonic, or carboxylic acid group, and the solvent employed is an aqueous solution of a base.

18. A process according to any of claims 1 to 16, in which the composition contains a photopolymerisable compound (B) having in the molecule at least one group of formula I but none of formula II and also at least one primary, secondary, or tertiary amino group, and the solvent employed is an aqueous solution of an acid.

## Revendications

1. Procédé pour créer une image, procédé caractérisé en ce que

(1) on expose à un rayonnement actinique une couche, appliquée sur un support, d'une composition liquide contenant un composé (A) qui renferme, dans une même molécule, à la fois au moins un radical répondant à la formule (I)

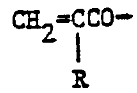

(I)

dans laquelle R représente un atome d'hydrogène ou un radical méthyle, et au moins un radical répondant à la formule (II)

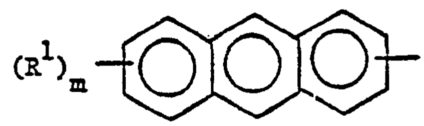

(II)

dans laquelle $R^1$ représente un atome de chlore ou de brome, un radical méthyle ou un radical nitro et m est égal à 0, à 1 ou à 2, cette exposition étant telle que la couche se solidifie par photopolymérisation de (A) par l'intermédiaire du ou des radicaux de formule I et devienne pratiquement non collante mais tout en conservant largement son aptitude à se photoréticuler, puis

(2) on expose la couche ainsi solidifiée, à travers un cliché portant une image présentant des endroits pratiquement opaques et des endroits pratiquement transparents, à une quantité de rayonnement actinique beaucoup plus grande de telle façon que le ou les endroits ainsi surexposés de la couche photopolymérisée subisse une photoréticulation par l'intermédiaire du ou des radicaux de formule II, et

(3) on développe l'image en dissolvant dans un solvant les endroits non photoréticulés de la couche.

2. Procédé selon la revendication 1, caractérisé en ce que le composé (A) contient, par molécule moyenne, au plus quatre radicaux de formule I.

3. Procédé selon l'une des revendications 1 et 2, caractérisé en ce que le composé (A) contient, par molécule moyenne, au plus quatre radicaux de formule II.

4. Procédé selon l'une quelconque des revendications précédentes, caractérisé en ce que le ou les radicaux de formule I est ou sont fixés directement sur un ou des atomes de carbone, d'oxygène ou d'azote.

5. Procédé selon l'une quelconque des revendications précédentes, caractérisé en ce que le ou les radicaux de formule II est ou sont fixés directement sur un ou des atomes de carbone, d'oxygène ou d'azote.

6. Procédé selon l'une quelconque des revendications 1 à 3, caractérisé en ce que le composé (A) répond à la formule

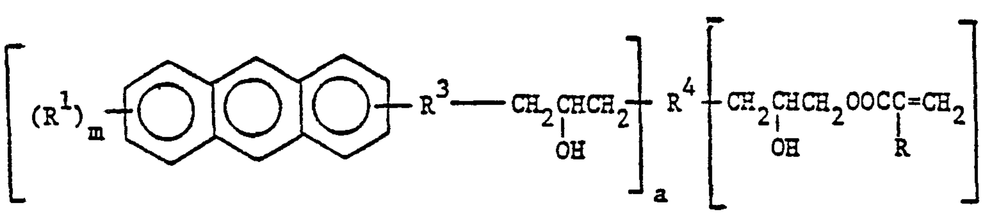

(X)

dans laquelle a et b représentent chacun, indépendamment l'un de l'autre, un nombre entier au moins égal à 1, R, $R^1$ et m ont les significations données à la revendication 1, $R^3$ représente un radical —COO—,

—O—, —$R^2$O—, —NH— ou —$SO_3$—, le symbole $R^2$ désignant un radical alkylène ou alkylidène contenant de 1 à 4 atomes de carbone, et $R^4$ représente le radical qui reste lorsqu'on a enlevé (a + b) radicaux glycidyles directement fixés à un atome d'oxygène, d'azote ou de soufre d'un composé contenant au moins (a + b) radicaux glycidyles de ce genre.

7. Procédé selon l'une quelconque des revendications 1 à 3, caractérisé en ce que le composé (A) répond à la formule XV

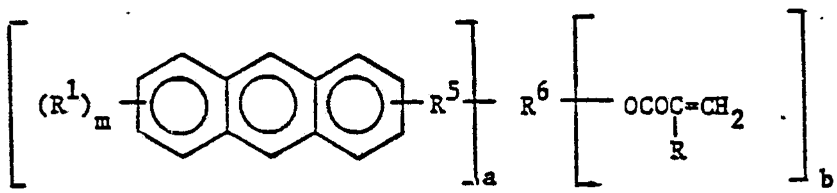

(XV)

dans laquelle a et b ont chacun les significations indiquées à la revendication 6, R, $R^1$ et m ont les significations données à la revendication 1, $R^5$ représente un radical —COO— ou —NHCOO—, et $R^6$ représente le radical que laisse un composé contenant au moins (a + b) radicaux hydroxy alcooliques après qu'on l'a amputé de (a + b) radicaux hydroxy de ce genre.

8. Procédé selon l'une quelconque des revendications 1 à 3, caractérisé en ce que le composé (A) est un ester-acétal qui contient dans sa molécule au moins un radical de formule XIX

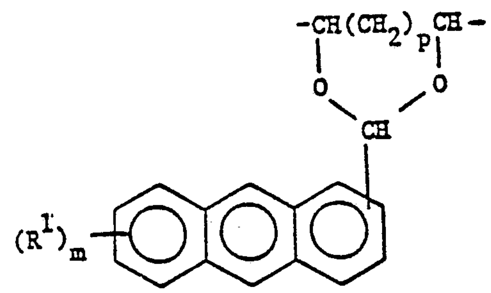

(XIX)

et au moins un radical de formule XX

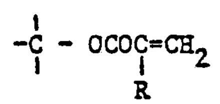

(XX)

formules dans lesquelles R, $R^1$ et m ont les significations données à la revendication 1 et p est égal à 0, à 1, à 2 ou à 3.

9. Procédé selon l'une quelconque des revendications 1 à 3, caractérisé en ce qu'on utilise, comme composé (A), un amide de formule XXI

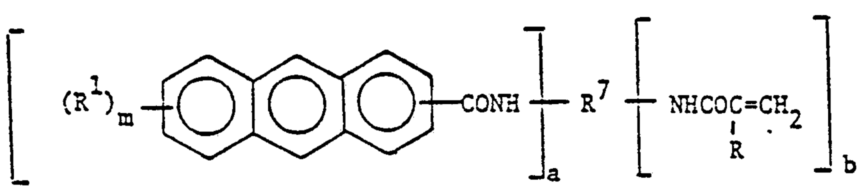

(XXI)

ou un urée-amide de formule XXII

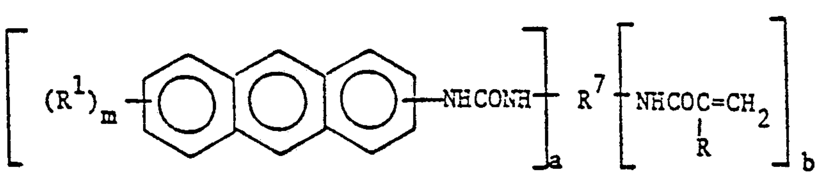

(XXII)

formules dans lesquelles R, $R^1$ et m ont les significations données à la revendication 1, a et b ont les significations données à la revendication 6, et $R^7$ représente un radical obtenu par enlèvement de (a + b) radicaux amino primaires d'un composé contenant au moins (a + b) radicaux amino de ce genre.

10. Procédé selon la revendication 1 caractérisé en ce que le composé (A) répond à la formule générale XXVI

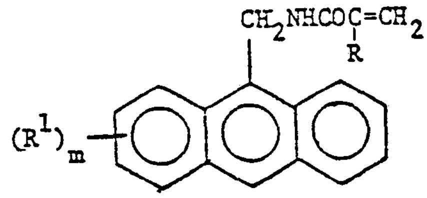

(XXVI)

dans laquelle R, $R^1$ et m ont les significations données à la revendication 1.

11. Procédé selon la revendication 1 caractérisé en ce que le composé (A) répond à la formule générale XXVII

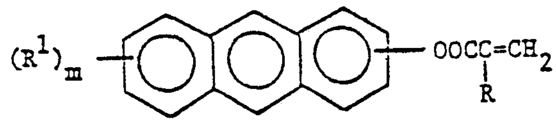

(XXVII)

dans laquelle R, $R^1$ et m ont les significations données à la revendication 1.

12. Procédé selon la revendication 1 caractérisé en ce que le composé (A) répond à la formule générale XXVIII

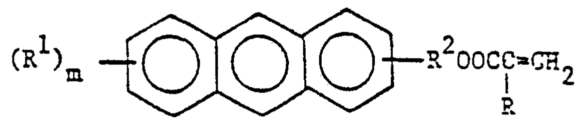

(XXVIII)

dans laquelle R, $R^1$ et m ont les significations données à la revendication 1 et $R^1$ a la signification donnée à la revendication 6.

13. Procédé selon la revendication 1 caractérisé en ce que le composé (A) répond à la formule générale XXIX

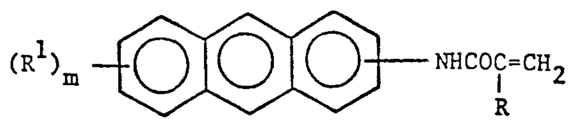

(XXIX)

dans laquelle R, $R^1$ et m ont les significations données à la revendication 1.

14. Procédé selon la revendication 1 caractérisé en ce que le composé (A) est un ester répondant à la formule XXX

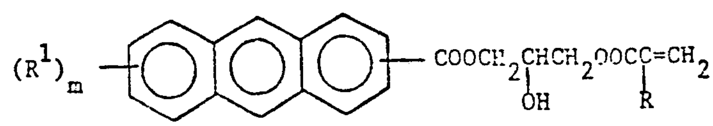

(XXX)

dans laquelle R, $R^1$ et m ont les significations données à la revendication 1.

15. Procédé selon l'une quelconque des revendications 1 à 9 et 11 à 14, caractérisé en ce que le radical de formule II est un radical anthryle-1, anthryle-2 ou anthryle-9.

16. Procédé selon la revendication 1 caractérisé en ce qu'on utilise, comme composé (A), l'anthracène-carboxylate-9 d'acryloyloxy-3 hydroxy-2 propyle, l'anthracène-carboxylate-9 de méthacryloyloxy-3 hydroxy-2 propyle ou l'acrylate d'(anthryl-9 méthyle).

17. Procédé selon l'une quelconque des revendications précédentes, caractérisé en ce que la composition renferme en outre un composé photopolymérisable (B) dont la molécule contient au moins un radical de formule I mais ne contient pas de radical de formule II et contient au moins un radical d'acide sulfonique, phosphonique ou carboxylique libre, et en ce que le solvant utilisé est une solution aqueuse d'une base.

18. Procédé selon l'une quelconque des revendications 1 à 16, caractérisé en ce que la composition renferme un composé photopolymérisable (B) dont la molécule contient au moins un radical de formule I mais ne contient pas de radical de formule II et contient au moins un radical amino primaire, secondaire ou tertiaire, et en ce que le solvant utilisé est une solution aqueuse d'un acide.